Europäisches Patentamt

European Patent Office

Office européen des brevets

(11) Publication number: **0 074 305**
**A2**

# (12) EUROPEAN PATENT APPLICATION

(21) Application number: 82401569.7

(22) Date of filing: 24.08.82

(51) Int. Cl.³: **G 06 F 11/20**

(30) Priority: 24.08.81 US 295418

(43) Date of publication of application:
16.03.83 Bulletin 83/11

(84) Designated Contracting States:
DE FR GB IT NL

(71) Applicant: FAIRCHILD CAMERA & INSTRUMENT
CORPORATION
464 Ellis Street
Mountain View California 94042(US)

(72) Inventor: Tickle, Andrew C.
1222 Richardson Avenue
Los Altos California 94022(US)

(74) Representative: Chareyron, Lucien et al,
Schlumberger Limited 42, rue Saint-Dominique
F-75340 Paris Cedex 07(FR)

(54) Fault isolating memory decoder.

(57) Logic elements are added to a conventional decoder to allow one or more defective blocks of columns to be isolated and one or more redundant blocks of columns to be substituted. The redundant block of columns is programmed by non-volatile latches. A repair address is stored in the latches. When the decoded address to a block of columns is the same as the repair address, the redundant block of columns is selected and all other blocks of columns are de-selected. Normal column block addressing is unaffected when the decoded address is different from the repair address.

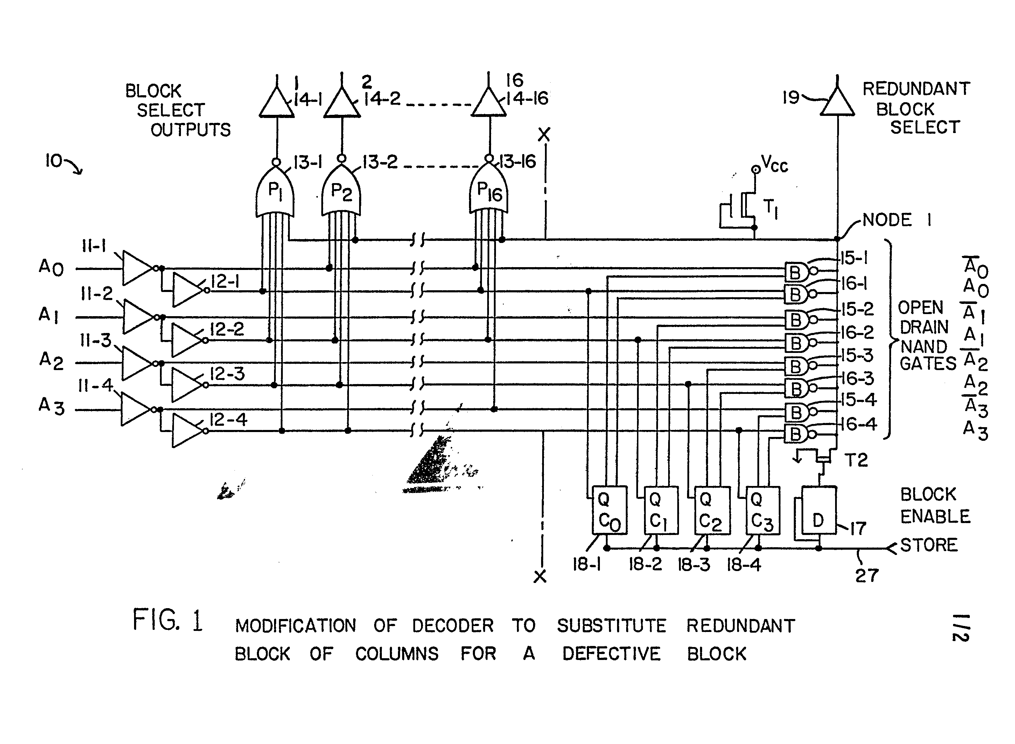

FIG. 1  MODIFICATION OF DECODER TO SUBSTITUTE REDUNDANT BLOCK OF COLUMNS FOR A DEFECTIVE BLOCK

EP 0 074 305 A2

0074305

# FAULT ISOLATING DECODER

## BACKGROUND OF THE INVENTION

### Field of the Invention

This invention relates to memory circuits containing rows and columns of memory cells and to a method and structure for allowing defective columns of memory cells to be isolated and spare columns of memory cells substituted.

### Description of the Prior Art

The detection of faulty bits in memory circuits and the isolation of these bits has been proposed. Thus, 16K memory circuits have been disclosed wherein a selected number of faulty columns of memory cells can be isolated from the main circuit and replaced with redundant columns contained on the same chip. Other parties have proposed the use of laser beams to open polysilicon links to remove faulty columns of memory cells from an active memory circuit and replace the faulty columns with redundant columns of memory cells formed elsewhere on the chip. These techniques require the testing and isolation of the faulty column prior to the packaging of the device. Moreover, such redundant structures use a substantial amount of extra silicon, thereby increasing chip size and necessarily reducing yield. Memory cost is also increased as chip size increases.

### SUMMARY

It is a general object of this invention to provide a method and structure for isolating a fault in a semiconductor memory.

This and other objects are attained, in accordance with one aspect of the invention, by a method of testing a semiconductor memory circuit containing a plurality of blocks of columns of memory cells and at least one redundant block of columns of memory cells which comprises: selecting the address of each of said plurality of blocks of columns of memory cells in sequence and testing the status of each bit in each of said plurality of blocks of columns of memory cells during the time that said block of columns is addressed; and storing the address of the first block of columns of memory cells to contain one or more defective bits in a non-volatile memory latch, thereby to thereafter disable said first block of columns of memory cells containing one or more defective bits when its address is received and to substitute therefor a redundant block of memory cells.

Another aspect includes a memory circuit comprising: a plurality of blocks of columns of memory cells; at least one redundant block of columns of memory cells contained on said memory circuit; and means for programming the address of a defective one of said blocks of columns containing at least one defective bit so as to select said one redundant block of columns for the storage or read-out of data whenever said defective one of said blocks of columns would normally be used.

DESCRIPTION OF THE DRAWINGS

Figure 1 discloses the modification to a standard decoder to substitute a redundant block of columns for a defective block of columns in accordance with this invention;

Figure 2 shows a bit line block select structure operable in conjunction with the structure of Figure 1 and;

Figures 3A and 3B illustrate one portion of the decoder structure shown in Figure 1.

DETAILED DESCRIPTION

While this description will be illustrated in conjunction with a specific embodiment of the invention, it should be understood that this description is exemplary only and not to be interpreted as limiting the scope of this invention.

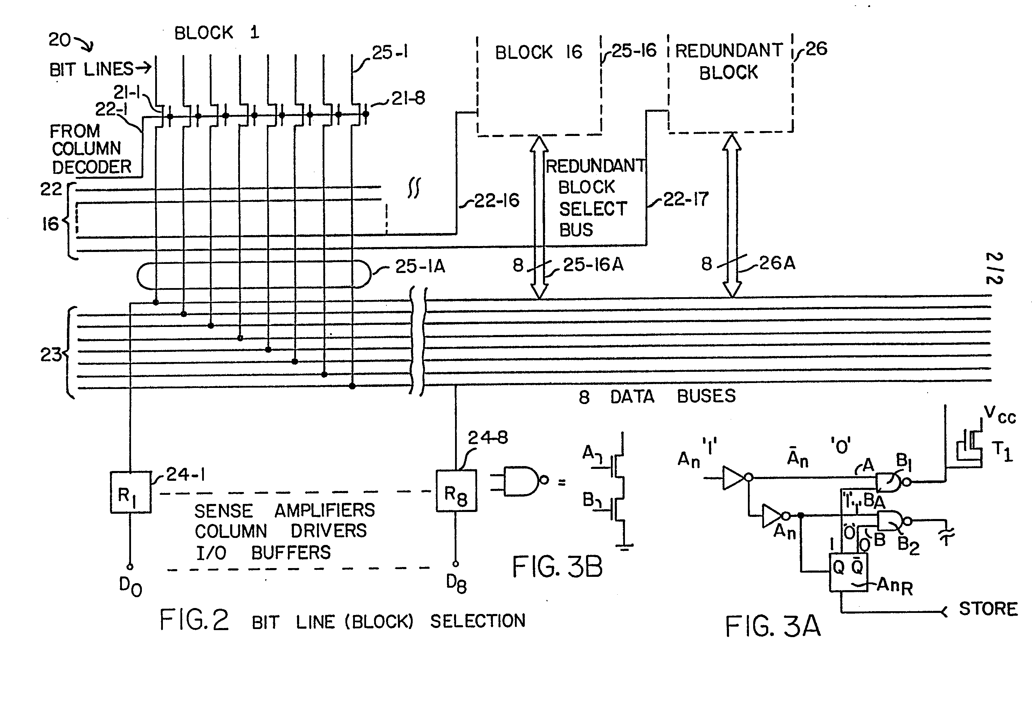

Figure 1 illustrates a decoder constructed in accordance with this invention. In Figure 1, a decoder for use with an N-channel, metal-oxide-semiconductor (NMOS) 16K (1K=1024 bits) non-volatile memory is illustrated. The 16K memory is structurally divided into 16 groups of eight columns, for a total of 128 columns. Each column comprises eight bits. Four address bit $A_0$ through $A_3$ select one of the 16 groups or blocks of columns using a conventional NOR gate decoder illustrated in Figure 1 as the region to the left of line xx. Each of the sixteen (16) block select output signals from amplifiers 14-1 through 14-16 (Figure 1) operates a corresponding group of eight (8) transfer gates (such as transfer gates 21-1 through 21-8 of block 1, operated by the signal on lead 22-1 from amplifier 14-1) shown in Figure 2 which couple the eight (8) bit lines of the selected block (such as bit lines 25-1A of block 1) to 8 bit data bus 23. The bit lines drive sense amplifiers R1 through R8 connected on a one-to-one basis to the eight (8) bit lines in data bus 23. Sense amplifiers 24-1 through 24-8 are connected to input/output (I/O) buffers (not shown) and produce output signals corresponding to the state of the corresponding bits of a selected eight-bit word in the block selected for read out. Writing and sensing are performed by sense amplifiers R1 through R8. Redundant block 26 is selected in a manner to be described by a signal on redundant-block-select bus 22-17.

Turning back to Figure 1, signals $A_0$, $A_0$, $A_1$ ... through $A_3$ are presented not just to NOR gates 13-1 through 13-16 connected such that a given NOR gate is uniquely activated in response to a unique signal on leads $A_0$ through $A_3$, but also to NAND gates 15-1 through 15-4 and 16-1 through 16-4. Signals $A_0$, $A_1$, $A_2$ and $A_3$ are transmitted through inverters 11-1 through 11-4 respectively, and 12-1 through 12-4 respectively, to be presented to one input lead of NAND gates 16-1 through 16-4 while signals $A_0$, $A_1$, $A_2$ and $A_3$ are generated by transmitting signals $A_1$, $A_2$, $A_3$ and $A_4$ through inverters 11-1 through 11-4, respectively directly to the one input lead of NAND gates 15-1 through 15-4. NAND gates 15-1 through 15-4 and 16-1 through 16-4 comprise part of the redundant block select circuit. These NAND gates are programmed by non-volatile latches 18-1 through 18-4 (of well known design) activated by a store signal transmitted in a manner to be described shortly. Node 1 connected to the output leads from NAND gates 15-1 through 15-4 and 16-1 through 16-4 is normally at a low voltage level when the address decoded is different from the repair address stored in the non-volatile latches. Hence, the normal signal on node 1 does not affect normal decoding. However, when the decoded adress is the same as the repair address, the redundant block 26 (Fig. 2) is selected and all other blocks 25-1 through 25-16 (regardless of address) are unconditionally deselected by node 1 (Fig. 1) going high. When node 1 goes high, NOR gates 13-1 through 13-16 are all disabled (output signals low) and thus the redundant block 26 (Fig. 2) is selected for reading or writing while all other blocks regardless of address are unconditionally deselected. Thus, the defective block is isolated without uniquely addressing it.

The NAND gates 15-1 through 15-4 and 16-1 through 16-4 shown in Figure 1 are shown in more detail in Figures 3A and 3B. Each of these NAND gates (of which one is shown in Fig. 3A) is open drained and the output signal from each NAND gate is "OR" tied at node 1 (Figs. 1 and 3A) with the output signals from the other NAND gates 15-1 through 15-4 and 16-1 through 16-4. Node 1 is pulled up by transistor T1

to a high level of $V_{cc}$. Node 1 will be low if the output signal from one or more of NAND gates 15-1 through 15-4 and 16-1 through 16-4 is low when the input signals on the two input leads to a given one of these NAND gates are both high, thereby drawing node 1 to ground as shown in Figure 3B. Two NAND gates are associated with each address bit $A_n$. The logic elements which compare one bit $A_n$ of the active address with the corresponding bit $A_{NR}$ of the repair address are shown in Figure 3A. The A inputs of NAND gates B1 and B2 are always complementary. When $A_n$ is the same as $A_{NR}$ stored in latch 17, the A and B input signals to all eight gates 15-1 through 15-4 and 16-1 through 16-4 are complementary and the output signals from each of these eight gates remain high level open. When $A_n$ and $A_{NR}$ differ (as is the normal case), then either B1 or B2 will have logical ones at both input leads and therefore node 1 will be pulled low. This deselects the redundant block 26 (Fig. 2) and sets the fifth input lead of NOR gates 13-1 through 13-16 corresponding to $P_1$ through $P_{16}$ low so that these gates are enabled to function as conventional decoders, thereby selecting the desired one of blocks 1-16.

The data in the non-volatile latches 18-1 through 18-4 (Figure 1) is presented by the address lines $A_0$-$A_3$ latched and stored permanently within non-volatile latches 18-1 through 18-4 when a logical high signal is placed on the store bus 27 by error detecting circuitry of conventional design (not shown). Latches 18-1 through 18-4 are of a well-known design and thus will not be described in detail. Latches 18-1 through 18-4 preferably comprise non-volatile memory elements capable of retaining the address of the column block to be replaced by the redundant block for the life of the part under all operating conditions.

The error detecting circuitry (not shown) may comprise a computer test system, such as the Sentry (mark of Fairchild Instrument Corporation) test system manufactured and sold by Fairchild Camera & Instrument Corporation.

During testing of the circuit of this invention, in either wafer form or as a packaged device, the error detecting circuitry determines if the data stored within a block is stored correctly. If not, the error detecting circuitry provides a logical high signal on store bus 27, thus causing the address $A_0$-$A_3$ of the defective column block to be permanently stored within latches 18-1 through 18-4.

Since the address to be stored in non-volatile latches 18-1 through 18-4 is unknown prior to testing, latches 18-1 through 18-4 are preset to all zeroes, or any arbitrary value, before testing starts. Thus, initially, the redundant block is substituted for block 1, when latches 18-1 through 18-4 are preset to all zeroes. All address combinations of all memory cells within the memory are then tested. If a single defective output bit is found, $A_0$ through $A_3$ of the address of the block of columns containing this bit are substituted into the non-volatile latches from the tester. Block 1 (as yet untested) is now accessed by address 0000 (applied to address leads $A_0$-$A_3$) and tested.

As a feature of this invention, the redundant block is always used and one of the 16 conventional blocks (whichever has its address programmed in latches 18-1 through 18-4 is never used.

The address of the block to be tested or accessed is entered through conventional address input leads $A_0$ through $A_3$. The command to store this address is the non-volatile latches 18-1 through 18-4 may be entered by using a tri-level signal on the suitable input pin which normally accepts only binary level (typically TTL level signals), thus eliminating the need for an additional external connection to be used solely to receive the "store" signal to be applied to store bus 27. The use of tri-level input signals is well known and thus any of the address input leads $A_4$ through $A_{10}$ (not shown) used for accessing the 1024 bits in any of the sixteen blocks 25-1 through 25-16 and redundant block 26 are suitable for use in receiving the tri-level store signal since address inputs $A_4$-$A_{10}$ do not select blocks 1-16 but only rows within blocks 1-16. Thus, whether the high level store signal (e.g., greater than 10 volts) is interpreted as a 1 or 0 address level is irrelevant since the entire block in the memory containing the defective bit or bits and addressed by $A_0$-$A_3$ is to be isolated in any case.

In order to avoid using the redundant block (which could contain a fault, it may be disabled by a non-volatile latch 17 which turns on transistor T2 and causes node 1 to be permanently pulled low.

Additional redundant blocks may be selected by adding one or more additional sets of programmable comparators such as NAND gates 15-1 through 15-4 and 16-1 through 16-4 and repair address latches 18-1 through 18-4 and isolation latches 17. Selection of the additional redundant block or blocks may be made, for example, by tri-level signals on row address pins.

The structure of this invention offers several advantages over the prior art. Fault isolation is accomplished during normal testing of either wafers or packaged devices. No additional equipment or handling of the devices is required and the substitution of the new columns for the columns containing faults is done during the testing operation. To do this, special signals are input to the chip on row address inputs to replace a defective column with the redundant column. Standard pin assignments are retained and thus the redundancy is obtained in a practical way using standard circuit configurations such as those associated with the well-known memory devices known in the semiconductor arts as the 2716, 2816, 2732, 2764, etc. and their electrically alterable versions. The products selected in this manner are repairable and the substitution of the redundant columns for a block of columns containing one or more defects has no significant effect on access time. Although column selection is slightly delayed by the structure of this invention, column selection does not in general need to be completed until row decoding has been completed and row decoding takes substantially longer than column selection even with the redundant block of columns substituted in accordance with this invention. The result of this invention is a significant increase in yield for a small increase in chip area. Moreover, when ROMs, PROMs, EPROMs, EEPROMs and other non-volatile memory circuits are manufactured in accordance with this invention, the non-volatile elements used with the fault isolation circuit of this invention are produced without any additional processing steps.

The increase in manufacturing cost caused by the slight increase in chip area is more than offset by the increase in yield obtainable using the structure of this invention.

Other embodiments of this invention will be obvious to those skilled in the art in view of the above disclosure, which is intended to be exemplary only, and not limiting.

I claim:

1. A method of testing a semiconductor memory circuit containing a plurality of blocks of columns of memory cells and at least one redundant block of columns of memory cells which is characterized by:

selecting the address of each of said plurality of blocks of columns of memory cells in sequence and testing the status of each bit in each of said plurality of blocks of columns of memory cells during the time that said block of columns is addressed; and

storing the address of the first block of columns of memory cells to contain one or more defective bits in a non-volatile memory latch, thereby to thereafter disable said first block of columns of memory cells containing one or more defective bits when its address is received and to substitute therefor a redundant block of memory cells.

2. A memory circuit comprising:

a plurality of blocks of columns of memory cells; characterized by

at least one redundant block of columns of memory cells contained on said memory circuit; and

means for programming the address of a defective one of said blocks of columns containing at least one defective bit so as to select said one redundant block of columns for the storage or read-out of data whenever said defective one of said blocks of columns would normally be used.

3. The structure of Claim 2 characterized in that said means for programming comprises

means for selecting one of a plurality of blocks of columns for storage or read-out of data;

means for disabling said means for selecting when the address of the selected block of columns corresponds to the address of said defective one of said blocks of columns; and means for accessing a redundant block of columns.

4. The structure of Claim 3 characterized in that said means for disabling and said means for accessing includes

means for storing the address of said defective one of said blocks of columns in a non-volatile form; and

means responsive to the address of said defective one of said blocks of columns to thereby disable said means for selecting and instead address said redundant block of columns.

5. The structure of Claim 4 characterized in that said means for storing the address of said defective one of said blocks of columns comprises a plurality of non-volatile latches containing the address of said defective one of said blocks of columns.

FIG. 1    MODIFICATION OF DECODER TO SUBSTITUTE REDUNDANT
BLOCK OF COLUMNS FOR A DEFECTIVE BLOCK

FIG.2 BIT LINE (BLOCK) SELECTION

FIG. 3B

FIG. 3A

2/2